# FASCICULE DE BREVET EUROPEEN

(11) **EP 1 491 904 B1**
(45) Date de publication et mention de la délivrance du brevet: **15.08.2007**
(21) Numéro de dépôt: 03291549.8
(22) Date de dépôt: 24.06.2003
(51) Int. Cl.: G01R 29/18

(54) **Procédé et dispositif d'identification du sens de rotation de deux phases d'un système de tension triphasé**
Verfahren und Vorrichtung zur Erkennung der Drehrichtung zweier Phasen in einem Dreiphasenspannungssystem
Method and device for the identification of the direction of rotation of two phases in a system with three-phase voltages

(43) Date de publication de la demande: 29.12.2004
(73) Titulaire: CHAUVIN ARNOUX, 75018 Paris (FR)
(72) Inventeur: Arnoux, Daniel, 75018 Paris (FR); Arnoux, Axel, 75018 Paris (FR); Kressic, Jean, 75018 Paris (FR)
(74) Mandataire: Thinat, Michel

(56) Documents cités:
- BE-A- 1 001 712
- DE-A- 4 002 603
- DE-U- 29 815 829
- GB-A- 2 091 961
- US-A- 4 495 461
- US-A- 6 144 925
- CARTY, LEURIDAN: "Phase-reversal protector trips main contactor" ELECTRONICS INTERNATIONAL, vol. 55, 1982, page 173 XP002262198
- PALIHAWADANA C W W: "MONITOR SHOWS THREE-PHASE SEQUENCE" ELECTRONICS WORLD AND WIRELESS WORLD, REED BUSINESS PUBLISHING, SUTTON, SURREY, GB, vol. 100, no. 1700, 1 juillet 1994 (1994-07-01), page 602 XP000445005 ISSN: 0959-8332

## Description

L'invention concerne un procédé d'identification du sens de rotation de deux signaux électriques périodiques de la même fréquence, présents chacun sur un conducteur électrique, notamment d'un système de tension triphasé, selon lequel on prélève des signaux sur les deux conducteurs et détermine le sens de rotation par mise en relation des signaux prélevés, à l'aide d'un dispositif comportant une liaison à la terre via l'utilisateur de ce dernier. L'invention concerne également un appareil pour la mise en oeuvre de ce procédé.

Des procédés et appareils de ce type sont déjà connus. Ainsi, on connaît un procédé qui est basé sur l'utilisation de deux fils raccordés à deux phases seulement et d'une électrode de toucher pour l'application d'un doigt de l'utilisateur. Ce procédé implique l'utilisation d'un pont diviseur essentiellement constitué de résistances et présente un inconvénient en cas de port de gants isolants. D'autre part, la liaison capacitive avec l'utilisateur provoque un déphasage qui fausse l'indication. De plus, la référence électrique du système, même sans gants, n'est pas assurément le potentiel de la terre. Pour la sécurité de l'utilisateur, il n'y a pas d'isolement, mais seulement une limitation de courant, qui est seulement efficace dans des conditions d'utilisation normales.

Un autre procédé connu utilise deux fils avec mémorisation d'une phase, comparée à une autre phase, avec ouverture d'une fenêtre temporelle. Ce procédé présente l'inconvénient d'exiger une opération dans un temps très court sur un réseau et ne fonctionne pas correctement sur des groupes électrogènes à cause de l'instabilité. D'autre part, il ne fonctionne que sur une plage de fréquences très réduite et il faut pouvoir différencier les phases du neutre pour éviter une erreur d'indication de sens de rotation suite à un mauvais raccordement.

Le document DE 298 15 829 U décrit un procédé et un appareil d'identification du sens de rotation de deux signaux électriques périodiques, présents sur deux conducteurs électriques selon lequel on prélève les signaux sur les deux conducteurs par deux fils d'un appareil de test pourvus d'une liaison à la terre via l'utilisateur de l'appareil et détermine ledit sens de rotation à partir des informations fournies par les deux signaux, l'un des deux signaux de phase servant de référence de tension. Ledit document divulgue également un déphasage dû à la liaison à la terre via l'utilisateur.

L'invention a pour but de proposer un procédé et un appareil qui pallie les inconvénients de l'état de la technique, qui viennent d'être énoncés.

Ce but est atteint par le procédé selon la revendication 1.

Selon une caractéristique de l'invention, l'une des deux phases est reliée à la masse interne pour servir de référence en tension et le prélèvement du signal sur l'autre phase se fait par l'intermédiaire d'une liaison capacitive destinée à compenser le déphasage induit par la capacité de liaison avec la terre, via l'utilisateur.

L'invention sera mieux comprise, et d'autres buts, caractéristiques, détails et avantages de celle-ci apparaîtront plus clairement au cours de la description explicative qui va suivre faite en référence aux dessins annexés donnés uniquement à titre d'exemple illustrant un mode de réalisation de l'invention et dans lesquels :
- la figure 1 est une vue synoptique, sous forme d'un schéma bloc, de l'appareil de mise en oeuvre du procédé selon l'invention, et
- les figures 2A et 2B illustrent deux variantes des étapes du procédé selon l'invention et du fonctionnement de l'appareil de mise en oeuvre de ce procédé.

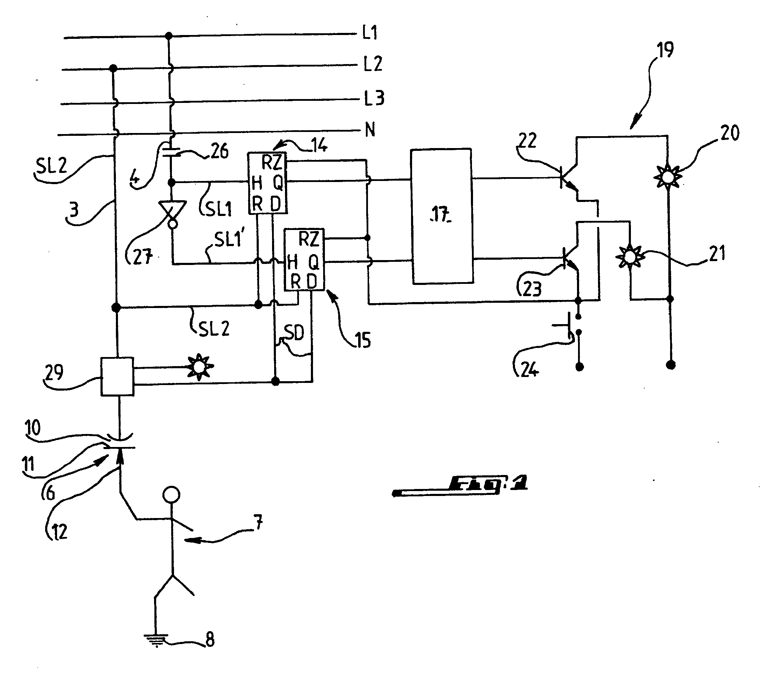

Sur le schéma synoptique de la figure 1, on a indiqué par des références L1, L2 et L3 les trois conducteurs de phase d'un réseau triphasé, dont le sens de la rotation de phase doit être déterminé à l'aide d'un appareil selon l'invention, désigné par la référence générale 1. Le neutre du réseau, noté N, reste libre dans le cadre de l'invention.

L'appareil selon l'invention comporte deux fils 3, 4 de prélèvement des signaux électriques sur des conducteurs de phase L1 à L3, chaque fil se terminant par une pointe de prélèvement ou de toucher, de façon connue en soi, constituant une entrée de l'appareil. Dans le cas de la figure 1, donnée à titre d'exemple, les fils 3 et 4 sont reliés aux phases L1 et L2 et l'appareil a donc pour mission d'établir le sens de rotation de ces deux phases dans le système triphasé représenté comportant les trois phases L1 à L3. L'appareil comporte en outre une zone de toucher 6 pour l'application d'un doigt de l'utilisateur, comme cela est illustré par la représentation schématique en 7 de l'utilisateur montré debout sur la terre indiquée en 8.

Plus précisément, l'appareil comporte une capacité de liaison avec la terre 8, formée par un élément métallique 10 disposé à l'intérieur du boîtier de l'appareil, à une certaine distance de la paroi indiquée schématiquement en 11 de ce boîtier. Celui-ci comporte au niveau de l'élément 10, sur la face extérieure de la paroi 11 une zone de toucher comme cela est encore indiqué schématiquement en 12. La paroi 11 du boîtier et l'intervalle d'air entre celle-ci et l'élément métallique 10 servent de diélectrique pour la capacité de liaison.

L'appareil 1 comporte encore deux bascules du type D 14 et 15 qui sont destinées à déterminer la rotation des deux phases choisies, dans l'exemple représenté les phases L1 et L2. Les sorties Q des bascules 14 et 15 sont reliées par l'intermédiaire d'un circuit de porte logique de type "OU exclusif" 17 à un dispositif d'affichage 19 comportant deux voyants 20, 21 avantageusement en forme de diodes électroluminescentes (ED), le voyant 20 étant destiné à afficher l'état de sortie Q de la bascule 14 et le voyant 21 l'état à la sortie Q de la bascule 15. Les deux voyants 20, 21 sont montés chacun dans le circuit collecteur d'un transistor 22, 23 dont les émetteurs sont interconnectés et reliés par l'intermédiaire d'un contact interrupteur 24 à un potentiel de la source d'alimentation en énergie électrique du dispositif d'affichage 19.

Selon une caractéristique essentielle de l'invention, l'une des phases, dans l'exemple représenté la phase L1 est reliée par l'intermédiaire d'une capacité 26, directement à l'entrée d'horloge de la bascule 14 et, par l'intermédiaire d'un inverseur 27, à l'entrée d'horloge H de la bascule 15.

La seconde phase L2 dans l'exemple représenté est reliée par le fil d'entrée 3 de l'appareil aux bornes de référence R des deux bascules 14 et 15, d'une part, et, d'autre part, par l'intermédiaire d'un dispositif 29 qui a pour fonction d'appliquer aux entrées de données D des bascules 14 et 15 le signal représentant le signe positif ou négatif, c'est-à-dire la valeur logique, de la tension existant entre la phase L2 et la terre 8, comme il sera expliqué ci-après. La capacité 26 dans le fil d'entrée 4 a pour fonction de compenser le déphasage occasionné par la capacité 6 de liaison avec la terre, via l'utilisateur 7.

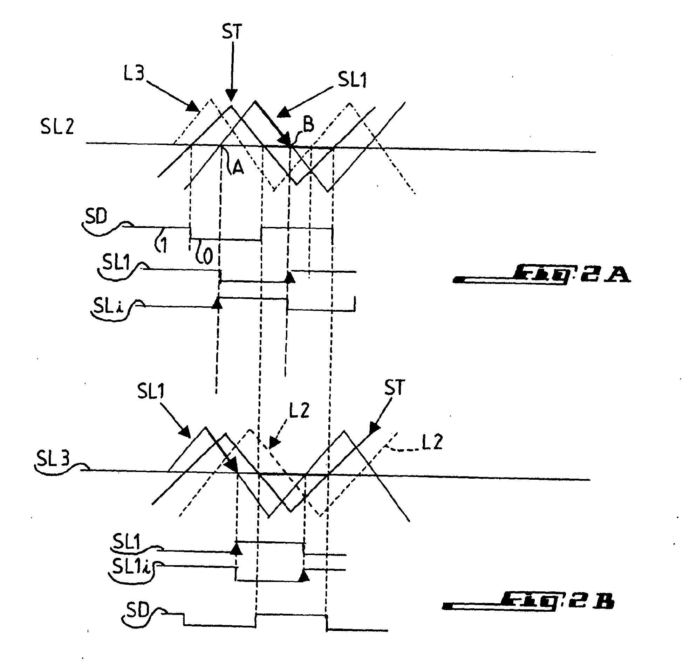

On décrira ci-après, en se référant aux figures 2A et 2B, le fonctionnement de l'appareil 1 selon l'invention et les différentes étapes du procédé que cet appareil met en oeuvre.

La figure 2A concerne le cas d'utilisation représenté sur la figure 1 où il s'agit de déterminer le signe de l'angle de phase entre les deux phases L1 et L2. Dans un but de simplification, les signaux de phase de forme normalement sinusoïdale sont représentés par des signaux évaluant dans le temps linéairement. Etant donné que sur la figure 1 le signal de la phase L2 sert de référence en tension en étant appliqué aux bornes de référence R constituant la masse interne de l'appareil, le signal SL2 de la phase L2 est montré constant et le signal ST représentatif de la terre est périodique et constitue un signal alternatif par rapport au signal SL2 de référence. Le signal SL1 de la phase L1 appliqué par l'intermédiaire de la capacité 26 aux entrées horloge H des bascules de type D 14 et D 15 constitue également un signal alternatif par rapport au signal de référence SL2.

Les bascules 14 et 15 reçoivent ainsi trois signaux, à savoir un premier signal SL1 aux entrées d'horloge H, un deuxième signal formé par le signal SL2 servant de référence et appliqué à l'entrée R de référence et de masse interne, et un troisième signal de repérage de phase du deuxième signal SR2 par rapport à la terre 8, qui est positif ou négatif par rapport à cette dernière. Ce troisième signal est appliqué aux entrées de données D des bascules.

La figure 2A montre aussi l'évolution du signal SD. On constate que ce signal représente un état logique 1 ou 2 selon que le troisième signal ST est positif ou négatif par rapport au signal de référence SL2. La figure 2A illustre également les signaux d'horloge SL1 appliqués à l'entrée H de la bascule 14 et le signal SL1i, inversé par l'inverseur 27 par rapport au signal SL1 à l'entrée d'horloge H de la bascule 15.

Il est à noter que le procédé ne nécessite l'utilisation d'une bascule, à savoir la bascule 14, la bascule 15 constituant un avantage supplémentaire, comme il sera expliqué plus loin.

Etant donné que la spécificité d'une bascule du type D est de transférer à sa sortie Q l'information présente à l'entrée de donnée D lors de l'apparition à l'entrée d'horloge d'un événement, tel que le passage par zéro, dans le cas présent, du signal SL1, la sortie Q de la bascule 14 indique le signe de l'angle de phase entre le signal de phase SL1 et le signal de phase SL2. En effet, comme on le voit clairement sur la figure 2A, le signe de l'angle de phase du signal SL1, par rapport au signal SL2 change aux points A et B pour devenir positif et négatif et c'est à ces points A et B que le signal d'horloge à l'entrée d'horloge H change, en faisant apparaître à la sortie Q les états logiques de l'entrée de données SD, qui sont différents aux points A et B. L'état logique à la sortie Q détermine si oui ou non le voyant 20 est éclairé ou non, en signalant ainsi le signe de phase et le sens de rotation entre les phases L1 et L2 du système triphasé.

Etant donné que la bascule 15 reçoit un signal d'horloge inversé par rapport au signal d'horloge appliqué à la bascule 14, l'état logique à sa sortie Q est différent par rapport au signal de sortie de la bascule 4.

Les deux bascules 14 et 15 sont prévues pour permettre une confirmation de l'interprétation des signaux d'entrée. Le montage de type "OU exclusif" 17, qui est intercalé entre les bascules 14 et 15 et le dispositif d'affichage 19 interdit toute application erronée de deux voyants allumés simultanément.

Les signaux venant des deux phases étant fiables, en cas de mauvais couplage de la troisième en liaison avec la terre, les deux bascules seraient dans le même état et aucun des voyants 20, 21 ne serait activé. Par contre, l'inversion des signaux d'horloge aux bascules 14 et 15 permet l'allumage d'un voyant dans le sens de rotation direct et de l'autre dans le sens de rotation inverse.

La figure 2B illustre le cas où le premier signal servant de signal d'horloge aux bascules est le signal SL1 présent sur la phase L1 est le signal servant de référence et le signal SL3 présent sur la phase L3.

L'appareil de test selon l'invention, du fait qu'une entrée est couplée capacitivement avec la terre, peut servir, à l'aide du circuit de repérage 29, pour détecter la présence des phases en opposition avec le neutre. Ce circuit d'entrée est ainsi commun à la détection de phase et au repérage du sens de rotation des phases.

Le contact interrupteur 24, en forme d'un bouton-poussoir est placé à proximité de l'élément capteur capacitif 6 du signal de terre, afin d'obliger l'utilisateur d'y placer un doigt. Si le bouton-poussoir n'est pas fermé, les circuits d'excitation des voyants 20, 21 sont ouverts et les voyants sont ainsi empêchés de s'allumer.

L'interrupteur 24 sert également, au relâché, à effectuer une remise à zéro des deux bascules 14 et 15 par l'intermédiaire d'une connexion de sa borne reliée aux circuits à l'entrée de remise à zéro Rz des bascules de la manière représentée sur la figure 1.

Il ressort de la description de l'invention, qui vient d'être faite, que les principaux aspects de l'invention résident dans l'utilisation du potentiel d'une phase comme référence et une liaison capacitive pour les autres signaux et d'appliquer ce principe à un système de repérage de la présence des phases en se servant d'un circuit commun.

## Revendications

1. Procédé d'identification du sens de rotation de deux signaux électriques périodiques (SL1,SL2), présents sur deux conducteurs électriques (L1,L2), notamment d'un système de tension triphasé, selon lequel on prélève les signaux sur les deux conducteurs (L1,L2) par deux fils (3,4) d'un appareil de test pourvus d'une liaison à la terre (8) via l'utilisateur (7) de l'appareil et détermine ledit sens de rotation à partir des informations fournies par les deux signaux, l'un des deux signaux de phase (SL2) servant de référence de tension, l'autre signal de phase (SL1) est déphasé pour compenser le déphasage provoqué par la liaison à la terre via l'utilisateur, **caractérisé en ce que** la déphasage de l'autre signal est réalisé par un circuit d'entrée comprenant une capacité (26).

2. Procédé selon la revendication 1, **caractérisé en ce que** l'on détermine le sens de rotation lors du passage à zéro de la tension existant entre les deux signaux de phase (SL1, SL2)

3. Appareil pour la mise en oeuvre du procédé selon l'une des revendications précédente, l'appareil comprenant un fil de prélèvement du signal de phase (SL2) servant de référence, un fil de prélèvement de l'autre signal de phase (SL1), une liaison à la terre via l'utilisateur, et au moins un dispositif (14) adapté pour produire un signal représentatif du sens de rotation des phases en fonction du signal (SL2) servant de référence, de l'autre signal (SL1) après déphasage et du signal reçu par la liaison à la terre**caractérisé en ce qu'**il comprend un circuit d'entrée recevant l'autre signal de phase (SL1) et comportant une capacité (26) de compensation du déphasage provoqué par la mise à la terre via l'utilisateur.

4. Appareil selon la revendication 3, **caractérisé en ce que** le dispositif précité comporte une entrée (R) de réception du signal de phase (SL2) servant de référence, une entrée (H) de réception de l'autre signal (SL1) après déphasage et une entrée D de réception d'un signal représentatif du signe du signal de référence (SL2) par rapport à la terre (8).

5. Appareil selon la revendication 3, **caractérisé en ce qu'**il comporte une bascule du type D (14) recevant à son entrée de référence le signal de phase (SL2) servant de signal de référence, à son entrée d'horloge (H) l'autre signal de phase (SL1) après déphasage, et à son entrée de données (D) un signal représentatif du signe du signal de référence par rapport à la terre (8), l'état à la sortie (Q) de la bascule indiquant le sens de rotation des phases.

6. Appareil selon l'une des revendications 3 à 5, **caractérisé en ce qu'**il comporte un dispositif d'affichage 19 du sens de rotation des phases (L1, L2).

7. Appareil selon l'une des revendications 3 à 6, **caractérisé en ce que** les moyens de mise à la terre via l'utilisateur de l'appareil comportent un élément métallique à l'intérieur du boîtier de l'appareil, à une certaine distance de la paroi (11) de celle-ci, et une zone de toucher (12) sur la face extérieure du boîtier au niveau de l'élément métallique (10), le boîtier et l'intervalle entre l'élément métallique (10) et la paroi (11) servant de diélectrique.

8. Appareil selon l'une des revendications 3 à 7, **caractérisé en ce qu'**il comprend un dispositif (29) d'établissement du signe du signal de référence (SL2) par rapport à la terre (8) et d'application de ce signal à l'entrée de données D du dispositif d'établissement du sens de rotation (14).

9. Appareil selon la revendication 8, **caractérisé en ce que** le dispositif précité (29) est adapté pour repérer la présence d'un signal de phase (SL2) servant de phase de référence.

10. Appareil selon la revendication 9, **caractérisé en ce qu'**il comprend un contact interrupteur (24) prévu dans le circuit d'activation du dispositif d'affichage (19) du sens de rotation, qui est fermé lorsque l'utilisateur touche la zone de contact (12) du boîtier de l'appareil.

11. Appareil selon l'une des revendications 5 à 10, **caractérisé en ce qu'**il comprend une deuxième bascule (15) du type D montée en parallèle à la première bascule (14) du type D mais recevant à son entrée d'horloge (H) le signal de phase (SL1) inversé, cette deuxième bascule permettant de confirmer le résultat fourni par la bascule (14).

12. Appareil selon la revendication 11, **caractérisé en ce qu'**un montage du type OU "exclusif" est intercalé entre les bascules et le dispositif d'affichage (19) de façon à interdire toute indication erronée

## Claims

1. Method for identification of the direction of rotation of two periodic electrical signals (SL1, SL2), present on two electrical conductors (L1, L2), in particular of a three-phase voltage system, wherein the signals on the two conductors (L1, L2) are sampled by two wires (3, 4) of a test device provided with a connection to ground (8) via the user (7) of the device and said direction of rotation is determined from information supplied by the two signals, one of the two phase signals (SL2) serving as a voltage reference, the other phase signal (SL1) is phase-shifted to compensate the phase shift caused the connection to ground via the user, **characterised in that** the phase of the other signal is shifted by an input circuit comprising a capacitor (26).

2. Method according to claim 1, **characterised in that** the direction of rotation is determined at the zero crossing of the voltage existing between the two phase signals (SL1, SL2).

3. Apparatus for implementing the method according to either of the preceding claims, comprising a wire for sampling the phase signal (SL2) serving as a reference, a wire for sampling the other phase signal (SL1), a connection to ground via the user, and at least one device (14) adapted to produce a signal representative of the direction of rotation of the phases as a function of the signal (SL2) serving as a reference, the other signal (SL1) when phase-shifted and the signal received via the connection to ground, **characterised in that** it comprises an input circuit receiving the other phase signal (SL1) and including a capacitor (26) for compensating the phase shift caused by the connection to ground via the user.

4. Apparatus according to claim 3, **characterised in that** the aforementioned device has an input (R) for receiving the phase signal (SL2) serving as a reference, an input (H) for receiving the other signal (SL1) when phase-shifted, and an input (D) for receiving a signal representing the sign of the reference signal (SL2) relative to ground (8).

5. Apparatus according to claim 3, **characterised in that** it includes a D-type flip-flop (14) receiving at its reference input the phase signal (SL2) serving as a reference signal, at its clock input (H) the other phase signal (SL1) when phase-shifted, and at its data input (D) a signal representative of the sign of the reference signal relative to ground (8), the state at the output (Q) of the flip-flop indicating the direction of rotation of the phases.

6. Apparatus according to any one of claims 3 to 5, **characterised in that** it includes a device (19) for displaying the direction of rotation of the phases (L1, L2).

7. Apparatus according to any one of claims 3 to 6, **characterised in that** the means for grounding via the user of the apparatus include a metallic element inside the casing of the apparatus, at a certain distance from the wall (11) thereof, and a touch area (12) on the exterior face of the casing at the location of the metal element (10), the casing and the gap between the metallic element (10) and the wall (11) serving as dielectric.

8. Apparatus according to any one of claims 3 to 7, **characterised in that** it comprises a device (29) for establishing the sign of the reference signal (SL2) relative to ground (8) and for applying that signal to the data input (D) of the device (14) for establishing the direction of rotation.

9. Apparatus according to claim (8), **characterised in that** the aforementioned device (29) is adapted to identify the presence of a phase signal (SL2) serving as a reference phase.

10. Apparatus according to claim 9, **characterised in that** it comprises a switch contact (24) in the activation circuit of the device (19) for displaying the rotation direction that is closed if the user touches the contact area (12) of the casing of the apparatus.

11. Apparatus according to any one of claims 5 to 10, **characterised in that** it comprises a second D-type flip-flop (15) connected in parallel with the first D-type flip-flop (14) but receiving at its clock input (H) the inverted phase signal (SL1), this second flip-flop. confirming the result supplied by the flip-flop (14).

12. Apparatus according to claim 11, **characterised in that** an "exclusive" OR type circuit is inserted between the flip-flops and the display device (19) to prevent any erroneous indication.

## Patentansprüche

1. Verfahren zur Identifizierung der Drehrichtung zweier periodischer elektrischer Signale (SL1, SL2), die an zwei elektrischen Leitern (L1, L2) anliegen, insbesondere eines dreiphasigen Spannungssystems, durch das die Signale über die beiden Leiter (L1, L2) mittels zweier Drähte (3, 4) eines Testgeräts, die mit einem Erdungsanschluss (8) über den Abnehmer (7) des Geräts versehen sind, abgegriffen werden, und durch das die Drehrichtung ausgehend von den Informationen, die von den beiden Signalen übermittelt werden, bestimmt wird, wobei das eine der beiden Phasensignale (SL2) als Referenzspannung dient, das andere Phasensignal (SL1) phasenverschoben ist, um die durch den Erdungsanschluss über den Abnehmer verursachte Phasenverschiebung auszugleichen, **dadurch gekennzeichnet, dass** die Phasenverschiebung des anderen Signals durch eine Eingangsschaltung umgesetzt wird, die eine Kapazität (26) umfasst.

2. Verfahren nach Anspruch 1, **dadurch gekennzeichnet, dass** die Drehrichtung während des Nulldurchgangs der Spannung, der zwischen den beiden Phasensignalen (SL1, SL2) besteht, bestimmt wird.

3. Gerät zur Anwendung des Verfahrens nach einem der vorstehenden Ansprüche, wobei das Gerät einen als Referenz dienenden Probenahme-Draht des Phasensignals (SL2), einen Probenahme-Draht des anderen Phasensignals (SL1), einen Erdungsanschluss über den Abnehmer und mindestens eine Vorrichtung (14) umfasst, die dazu ausgelegt ist, ein repräsentatives Signal der Drehrichtung der Phasen in Abhängigkeit von dem als Referenz dienenden Signal (SL2), in Abhängigkeit von dem anderen Signal (SL1) nach der Phasenverschiebung und in Abhängigkeit von dem durch den Erdungsanschluss empfangenen Signal, zu erzeugen, **dadurch gekennzeichnet, dass** es eine Eingangsschaltung umfasst, die das andere Phasensignal (SL1) empfängt, und dass es eine Kapazität (26) zum Ausgleich der durch die Erdung über den Abnehmer verursachten Phasenverschiebung umfasst.

4. Gerät nach Anspruch 3, **dadurch gekennzeichnet, dass** die oben genannte Vorrichtung einen Eingang (R) zum Empfangen des als Referenz dienenden Phasensignals (SL2), einen Eingang (H) zum Empfangen des anderen Signals (SL1) nach der Phasenverschiebung und einen Eingang (D) zum Empfangen eines repräsentativen Signals des Zeichens des Referenzsignals (SL2) bezüglich der Erdung (8) umfasst.

5. Gerät nach Anspruch 3, **dadurch gekennzeichnet, dass** es einen Flip-Flop des Typs D (14) umfasst, der an seinem Referenzeingang das als Referenz dienende Phasensignal (SL2), an seinem Takteingang (H) das andere Phasensignal (SL1) nach der Phasenverschiebung und an seinem Dateneingang (D) ein repräsentatives Signal des Zeichens des Referenzsignals bezüglich der Erdung (8) empfängt, wobei der Status am Ausgang (Q) des Flip-Flops die Drehrichtung der Phasen angibt.

6. Gerät nach einem der Ansprüche 3 bis 5, **dadurch gekennzeichnet, dass** es eine Vorrichtung (19) zur Anzeige der Drehrichtung der Phasen (L1, L2) umfasst.

7. Gerät nach einem der Ansprüche 3 bis 6, **dadurch gekennzeichnet, dass** die Mittel zur Erdung über den Abnehmer des Geräts ein Metallelement im Inneren des Gerätegehäuses mit einem bestimmten Abstand zu dessen Innenwand (11) und einen Kontaktbereich (12) auf der Außenoberfläche des Gehäuses auf Höhe des Metallelements (10) umfassen, wobei das Gehäuse und der Abstand zwischen dem Metallelement (10) und der Innenwand (11) als Nichtleiter dienen.

8. Gerät nach einem der Ansprüche 3 bis 7, **dadurch gekennzeichnet, dass** es eine Vorrichtung (29) zur Etablierung des Zeichens des Referenzsignals (SL2) bezüglich der Erdung (8) und zur Anwendung dieses Signals am Dateneingang D der Vorrichtung zur Etablierung der Drehrichtung (14) umfasst.

9. Gerät nach Anspruch 8, **dadurch gekennzeichnet, dass** die vorstehend genannte Vorrichtung (29) dazu ausgelegt ist, die Gegenwart eines als Referenzphase dienenden Phasensignals (SL2) zu orten.

10. Gerät nach Anspruch 9, **dadurch gekennzeichnet, dass** es einen in der Aktivierungsschaltung der Vorrichtung (19) zur Anzeige der Drehrichtung vorgesehenen Kontaktschalter (24) umfasst, der geschlossen ist, wenn der Abnehmer den Kontaktbereich (12) des Gerätegehäuses berührt.

11. Gerät nach einem der Ansprüche 5 bis 10, **dadurch gekennzeichnet, dass** es einen zweiten Flip-Flop (15) des Typs D umfasst, der parallel zum ersten Flip-Flop (14) des Typs D angebracht ist, der jedoch an seinem Takteingang (H) das umgekehrte Phasensignal (SL1) empfängt, wobei dieser zweite Flip-Flop die Bestätigung des vom Flip-Flop (14) erhaltenen Ergebnisse ermöglicht.

12. Gerät nach Anspruch 11, **dadurch gekennzeichnet, dass** eine Schaltung vom Typ OU "exklusiv" so zwischen den Flip-Flops und der Anzeige-Vorrichtung (19) angebracht ist, um jede fehlerhafte Anzeige zu verhindern.
